# FASCICULE DE BREVET EUROPEEN

(11) **EP 1 329 916 B1**
(45) Date de publication et mention de la délivrance du brevet: **28.05.2008**
(21) Numéro de dépôt: 02360374.9
(22) Date de dépôt: 20.12.2002
(51) Int. Cl.: H01G 5/04

(54) **Capacité variable, filtre et sonde RMN comportant une telle capacité**
Variabler Kondensator, Filter und NMR-Messkopf, der diesen Kondensator verwendet
Variable capacitor, filter and NMR probe containing such a capacitor

(30) Priorité: 22.01.2002 FR 0200770
(43) Date de publication de la demande: 23.07.2003
(73) Titulaire: Bruker Biospin SA, 67160 Wissembourg (FR)
(72) Inventeur: Gonella, Olivier, 67240 Bischwiller (FR); Tyburn, Jean-Max, 67160 Wissembourg (FR); Brevard, Christian, 67160 Wissembourg (FR)
(74) Mandataire: Nuss, Pierre

(56) Documents cités:
- FR-A- 2 515 861

## Description

La présente invention concerne le domaine des composants électriques passifs, plus particulièrement les composants à propriétés capacitives, et a pour objet une capacité variable, ainsi qu'un filtre à hautes fréquences et une sonde RMN intégrant au moins une telle capacité.

Dans certaines applications, en particulier en liaison avec la résonance magnétique nucléaire (RMN), il est nécessaire de disposer de composants adaptés aux hautes fréquences pouvant supporter de fortes puissances. Il est bien entendu avantageux que de tels composants soient facilement ajustables, aisés à fabriquer et d'un coût de revient faible, et fassent état d'une bonne tenue au vieillissement.

Ainsi, en matière de capacités variables, il a été proposé une structure de capacité variable comprenant essentiellement, d'une part, un premier élément en matériau conducteur sous la forme d'une tige ou d'une barre au moins partiellement creuse, comportant un trou ou une perforation s'étendant axialement dans le corps dudit premier élément pour constituer une portion de tube et, d'autre part, un second élément également en matériau conducteur sous la forme d'une tige pouvant s'emboîter sur une profondeur variable dans ledit trou axial, la profondeur d'engagement du second élément dans le premier élément déterminant le degré de couplage capacitif entre eux, et donc la valeur de la capacité résultante.

Un tel condensateur ajustable tubulaire est, par exemple, connu de FR-A-2 515 861.

Ces capacités sont notamment utilisées pour la réalisation de filtres de haute fréquence.

Bien qu'une telle construction de capacité puisse supporter des courants dynamiques importants, sa tenue en tension n'est pas suffisante dans certaines applications, ou ne permet pas de garantir une sécurité suffisante vis à vis des risques d'arcage, en cas de surtension.

La présente invention a notamment pour but d'améliorer les capacités variables du type précité et de pallier aux inconvénients exposés ci-dessus.

A cet effet, l'invention propose une capacité variable ou réglable du type précité, caractérisée en ce que la portion de tube est pourvue sur sa face interne, préférentiellement sensiblement sur toute la profondeur du trou axial, d'une couche d'un matériau diélectrique, cette dernière s'étendant, de manière continue, par dessus le bord définissant l'ouverture d'accès dudit trou et sur une partie adjacente de la face externe de ladite portion de tube.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 1 est une vue partielle en coupe d'une capacité variable selon l'invention, et,
les figures 2A, 2B et 2C représentent en élévation latérale (figures 2A et 2B) ou en coupe longitudinale (figure 2C) les éléments constitutifs d'une capacité variable selon une variante de réalisation préférée de l'invention.

Comme le montrent les figures des dessins annexés, la capacité 1 comprend essentiellement, d'une part, un premier élément 2 en matériau conducteur sous la forme d'une tige ou d'une barre au moins partiellement creuse, comportant un trou ou une perforation 2' s'étendant axialement dans le corps dudit premier élément 2 pour constituer une portion de tube 2" et, d'autre part, un second élément 3 également en matériau conducteur sous la forme d'une tige pouvant s'emboîter sur une profondeur variable dans ledit trou axial 3', la profondeur d'engagement du second élément 3 dans le premier élément 2 déterminant le degré de couplage capacitif entre eux, et donc la valeur de la capacité résultante.

Conformément à l'invention, la portion de tube 2" du premier élément constitutif 2 est pourvue sur sa face interne, préférentiellement sensiblement sur toute la profondeur du trou axial 2', d'une couche 4 d'un matériau diélectrique, cette dernière s'étendant de manière continue par dessus le bord 2''' définissant l'ouverture d'accès dudit trou 2' et sur une partie adjacente de la face externe de ladite portion de tube 2".

Une telle constitution de la capacité 1 permet, outre de pallier aux inconvénients précités, également de réaliser une bonne simulation préalable des problèmes d'arcage en liaison avec l'élaboration de la géométrie des éléments.

Afin d'obtenir des caractéristiques électriques évoluant progressivement lors d'un mouvement de coulissement axial relatif entre les deux éléments 2 et 3, ainsi qu'un déplacement aisé et un guidage précis du second élément 3 dans le premier élément 2, ledit second élément 3 coulisse avec un contact glissant dans le premier élément 2, ces éléments 2 et 3 présentant avantageusement tous deux une section circulaire, au moins pour leurs surfaces respectives en regard.

Selon un mode de réalisation préférentiel de l'invention, la couche 4 de matériau diélectrique consiste en du polytétrafluoroéthylène (TEFLON - nom déposé) et présente une épaisseur sensiblement constante.

Il a été constaté par les inventeurs qu'une très bonne protection contre les arcs électriques était obtenue lorsque la longueur d'extension axiale 1 de la portion de couche 4" rapportée sur la face externe du premier élément 2 est supérieure à 10 %, avantageusement comprise entre 15 % et 60 %, préférentiellement entre 35 % et 55 % (meilleur compromis coût / performance), de la longueur d'extension axiale L de la portion de couche 4' rapportée sur la face interne de la portion de tube 2" définissant le trou axial 2'.

Ainsi, ladite longueur axiale 1 pourra être d'environ 20 mm pour une longueur axiale L de 45 mm et un diamètre intérieur du premier élément 2 d'environ 5 mm.

En variante, la portion de couche 4" externe pourra également recouvrir la totalité de la face extérieure du premier élément 2.

La couche de matériau diélectrique pourra, par exemple, être rapportée par dépôt sur les faces concernées de la portion de tube 2".

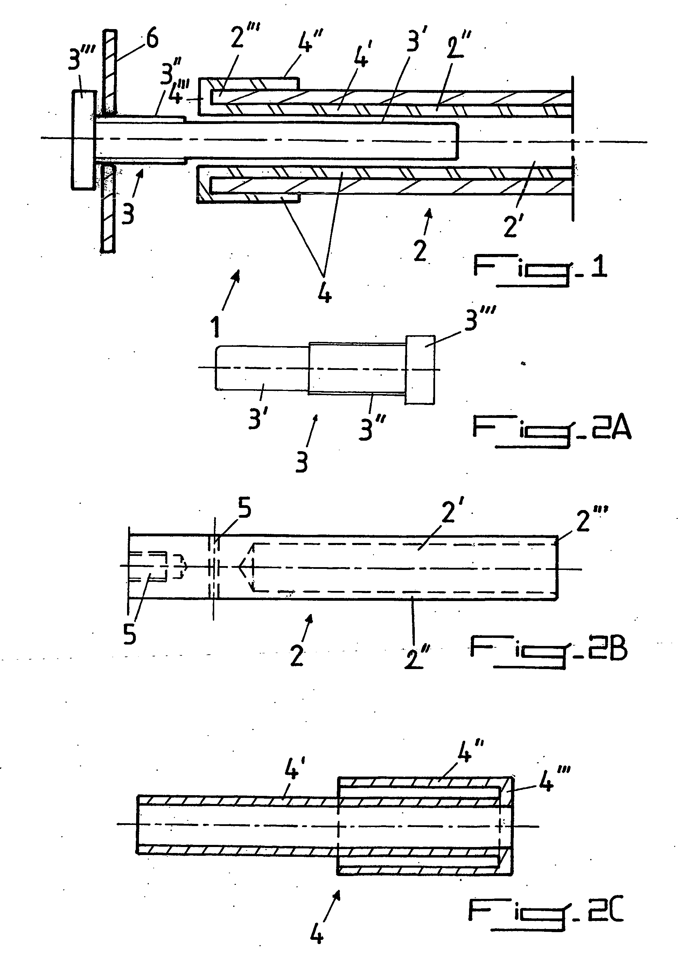

Toutefois, conformément à une variante de réalisation pratique avantageuse de l'invention, représentée aux figures 2A, 2B et 2C des dessins annexés, la couche de matériau diélectrique 4 est formée par un élément ou un corps, préférentiellement d'un seul tenant, rapporté par emmanchement sur le premier élément 2, ledit corps 4 étant constitué par un premier manchon 4' de plus petit diamètre et de plus grande longueur, par un second manchon 4" de plus grand diamètre et de plus petite longueur disposé autour dudit premier manchon 4' et par un anneau de jonction 4''' reliant les deux manchons 4' et 4" au niveau de l'un de leurs bords d'extrémité respectifs.

Comme le montre plus particulièrement la figure 2B des dessins annexés, le trou axial 2' est un trou borgne et le premier élément 2 présente au moins un autre perforation 5, filetée ou non, à extension axiale ou transversale, destinée à son montage ou à sa fixation.

Le cas échéant, ledit premier élément 2 pourra comporter un second trou axial 5, opposé au premier trou axial 2' et pourvu d'un filetage interne pour sa fixation et son réglage en position sur un support adapté.

Préférentiellement, et comme représenté sur la figure 2A des dessins annexés, le second élément 3 consiste en une vis présentant, du côté de l'extrémité opposée à la tête 3''', une partie non filetée 3', destinée à être engagée, préférentiellement de manière ajustée, dans le trou axial 2' du premier élément 2 (l'élément 3 formant ainsi une vis plongeuse).

Comme le montre partiellement la figure 1 des dessins annexés, les premier et second éléments 2 et 3 sont montés sur un corps support 6 (représenté en partie), le second élément 3 sous forme de vis étant solidarisé au niveau de sa partie filetée 3 contiguë à sa tête 3''', avec faculté de coulissement par rapport au premier élément 2 par rotation autour de son axe longitudinal.

En vue d'aboutir à une possibilité de réglage optimisée de la capacité variable 1, les parties filetée 3" et non filetée 3' de la vis 3 peuvent présenter des longueurs axiales sensiblement identiques.

La présente invention a également pour objet un filtre à hautes fréquences, notamment du type passe-bande, caractérisé en ce qu'il comprend au moins une capacité variable ou réglable 1 du type décrit ci-dessus (non représenté).

Enfin, la présente invention concerne également une sonde RMN de puissance, caractérisée en ce qu'elle comprend au moins une capacité variable ou réglable 1 du type décrit précédemment.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention, tel que défini par les revendications suivants.

## Revendications

1. Capacité variable ou réglable, notamment pour filtres de puissance haute-fréquence, comprenant essentiellement, d'une part, un premier élément en matériau conducteur sous la forme d'une tige ou d'une barre au moins partiellement creuse, comportant un trou ou une perforation s'étendant axialement dans le corps dudit premier élément pour constituer une portion de tube et, d'autre part, un second élément également en matériau conducteur sous la forme d'une tige pouvant s'emboîter sur une profondeur variable dans ledit trou axial, la profondeur d'engagement du second élément dans le premier élément déterminant le degré de couplage capacitif entre eux, et donc la valeur de la capacité résultante, **caractérisée en ce que** la portion de tube (2") est pourvue sur sa face interne, préférentiellement sensiblement sur toute la profondeur du trou axial (2'), d'une couche (4) d'un matériau diélectrique, cette dernière s'étendant, de manière continue par dessus le bord (2"') définissant l'ouverture d'accès dudit trou (2') et sur une partie adjacente de la face externe de ladite portion de tube (2").

2. Capacité variable selon la revendication 1, **caractérisée en ce que** le second élément (3) coulisse avec un contact glissant dans le premier élément (2), ces éléments (2 et 3) présentant tous deux une section circulaire.

3. Capacité variable selon Tune -quelconque des revendications 1 et 2, **caractérisée en ce que** la couche (4) de matériau diélectrique consiste en du polytétrafluoroéthylène et présente une épaisseur sensiblement constante et **en ce que** la longueur d'extension axiale (1) de la portion de couche (4") rapportée sur la face externe du premier élément (2) est supérieure à 10 %, avantageusement comprise entre 15 % et 60 %, préférentiellement entre 35 % et 55 %, de la longueur d'extension axiale (L) de la portion de couche (4') rapportée sur la face interne de la portion de tube (2") définissant le trou axial (2').

4. Capacité variable selon l'une quelconque des revendications 1 à 3, **caractérisée en ce que** la couche de matériau diélectrique (4) est formée par un élément ou un corps, préférentiellement d'un seul tenant, rapporté par emmanchement sur le premier élément (2), ledit corps (4) étant constitué par un premier manchon (4') de plus petit diamètre et de plus grande longueur, par un second manchon (4") de plus grand diamètre et de plus petite longueur disposé autour dudit premier manchon (4') et par un anneau de jonction (4"') reliant les deux manchons (4' et 4") au niveau de l'un de leurs bords d'extrémité respectifs.

5. Capacité variable selon l'une quelconque des revendications 1 à 4, **caractérisée en ce que** le trou axial (2') est un trou borgne et **en ce que** le premier élément (2) présente au moins un autre perforation (5), filetée ou non, à extension axiale ou transversale, destinée à son montage ou à sa fixation.

6. Capacité variable selon l'une quelconque des revendications 1 à 5, **caractérisé en ce que** le second élément (3) consiste en une vis présentant, du côté de l'extrémité opposée à la tête (3"'), une partie non filetée (3'), destinée à être engagée, préférentiellement de manière ajustée, dans le trou axial (2') du premier élément (2).

7. Capacité variable selon les revendications 5 et 6, **caractérisée en ce que** les premier et second éléments (2 et 3) sont montés sur un corps support (6), le second élément (3) sous forme de vis étant solidarisé au niveau de sa partie filetée (3) contiguë à sa tête (3"'), avec faculté de coulissement par rapport au premier élément (2) par rotation autour de son axe longitudinal.

8. Capacité variable selon l'une quelconque des revendications 6 et 7, **caractérisée en ce que** les parties filetée (3") et non filetée (3') de la vis (3) présentent des longueurs axiales sensiblement identiques.

9. Filtre à hautes fréquences, notamment du type passe-bande, **caractérisé en ce qu**'il comprend au moins une capacité variable ou réglable (1) selon l'une quelconque des revendications 1 à 8.

10. Sonde RMN de puissance, **caractérisée en ce qu**'elle comprend au moins une capacité variable ou réglable (1) selon l'une quelconque des revendications 1 à 8.

## Claims

1. A variable or adjustable capacitor, in particular for high-frequency power filters, substantially comprising, on the one hand, a first component made of conductive material in the form of an at least partially hollow rod or bar, comprising a hole or perforation extending axially into the body of said first component to form a tube portion and, on the other hand, a second component also made of conductive material in the form of a rod able to be fitted to a variable depth into said axial hole, the engagement depth of the second component in the first component determining the degree of capacitive coupling between them, and therefore the value of the resulting capacitance, **characterised in that** the tube portion (2") is provided on its internal face, preferably substantially over the whole depth of the axial hole (2'), with a layer (4) of dielectric material, the latter extending in a continuous manner over the edge (2"') defining the access aperture of said hole (2') and onto an adjacent part of the external face of said tube portion (2").

2. The variable capacitor according to claim 1, **characterised in that** the second component (3) slides in the first component (2) with sliding contact, these components (2 and 3) both having a circular section.

3. The variable capacitor according to either of claims 1 and 2, **characterised in that** the layer (4) of dielectric material consists of polytetrafluoroethylene and has a substantially constant thickness and **in that** the length of axial extension (1) of the layer portion (4") attached to the external face of the first component (2) is greater than 10%, advantageously between 15 % and 60 % and preferably between 35 % and 55 %, of the length of the axial extension (L) of the layer portion (4') attached to the internal face of the tube portion (2") defining the axial hole (2').

4. The variable capacitor according to any one of claims 1 to 3, **characterised in that** the layer (4) of dielectric material is formed by a component or a body, preferably in one piece, attached by fitting onto the first component (2), said body (4) being formed by a first sleeve (4') of smaller diameter and longer length, by a second sleeve (4") of larger diameter and smaller length disposed around said first sleeve (4') and by a junction ring (4"') connecting the two sleeves (4' and 4") in the region of one of their terminal edges.

5. The variable capacitor according to any one of claims 1 to 4, **characterised in that** the axial hole (2') is a blind hole and **in that** the first component (2) has at least one other threaded or non-threaded perforation (5), with an axial or transverse extension, designed to mount or fix it.

6. The variable capacitor according to any one of claims 1 to 5, **characterised in that** the second component (3) consists of a screw having, on the side at the opposite end to the head (3"') a non-threaded part (3') designed to be engaged, preferably in a close-fitting manner, in the axial hole (2') of the first component (2).

7. The variable capacitor according to claims 5 and 6, **characterised in that** the first and second components (2 and 3) are mounted on a support body (6), the second component (3) in the form of a screw being secured in the region of its threaded part (3) adjoining its head (3"') with a sliding facility relative to the first component (2) by rotating around its longitudinal axis.

8. The variable capacitor according to any one of claims 6 and 7, **characterised in that** the threaded parts (3") and non-threaded parts (3') of the screw (3) have substantially identical axial lengths.

9. A high-frequency filter, in particular of the band-pass type, **characterised in that** it comprises at least one variable or adjustable capacitor (1) according to any one of claims 1 to 8.

10. An NMR power sensor, **characterised in that** it comprises at least one variable or adjustable capacitor (1) according to any one of claims 1 to 8.

## Patentansprüche

1. Variabler oder regelbarer Kondensator, insbesondere für Filter mit Hochfrequenzleistung, der im Wesentlichen einerseits ein erstes Element aus einem leitfähigen Material in Form einer wenigstens teilweise hohlen Stange oder Stabs mit einem Loch oder einer Perforation, die sich axial im Körper des ersten Elements erstreckt, um einen Röhrenabschnitt zu bilden, und andererseits ein zweites Element ebenfalls aus einem leitfähigen Material in Form einer Stange, die sich auf einer variablen Tiefe in das axiale Loch einfügen kann, aufweist, wobei die Eingriffstiefe des zweiten Elements in das erste Element den Grad der kapazitiven Kopplung untereinander und somit den Wert der resultierenden Kapazität bestimmt, **dadurch gekennzeichnet, dass** der Röhrenabschnitt (2") auf seiner Innenseite, vorzugsweise im Wesentlichen auf der gesamten Tiefe des axialen Loches (2'), mit einer Schicht (4) aus einem dielektrischen Material versehen ist, wobei letztere sich fortlaufend von oben über den Rand (2"'), der die Zugangsöffnung des Lochs (2') bildet, und über einen benachbarten Teil der Außenseite des Röhrenabschnitts (2") erstreckt.

2. Variabler Kondensator nach Anspruch 1, **dadurch gekennzeichnet, dass** das zweite Element (3) mit einem Gleitkontakt in das erste Element (2) gleitet, wobei diese Elemente (2 und 3) beide einen kreisförmigen Querschnitt aufweisen.

3. Variabler Kondensator nach einem der Ansprüche 1 und 2, **dadurch gekennzeichnet, dass** die Schicht (4) aus dielektrischem Material aus Polytetrafluorethylen besteht und eine im Wesentlichen konstante Dicke aufweist, und dass die Länge der axialen Ausdehnung (I) des Abschnitts der Schicht (4"), die auf der Außenseite des ersten Elements (2) aufgetragen ist, mehr als 10%, vorteilhafterweise zwischen 15 % und 60 %, bevorzugt zwischen 35 % und 55 % der Länge der axialen Ausdehnung (L) des Abschnitts der Schicht (4'), die auf der Innenseite des Röhrenabschnitts (2"), der das axiale Loch (2') definiert, aufgetragen ist, beträgt.

4. Variabler Kondensator nach einem der Ansprüche 1 bis 3, **dadurch gekennzeichnet, dass** die Schicht aus dielektrischem Material (4) durch ein Element oder einen Körper, vorzugsweise aus einem Stück, gebildet ist, der/das durch Aufziehen auf das erste Element (2), gebildet ist, wobei der Körper (4) durch eine erste Hülse (4') mit kleinerem Durchmesser und größerer Länge, durch eine zweite Hülse (4") mit größerem Durchmesser und kleinerer Länge, der um die erste Hülse (4') herum angeordnet ist und durch einen Verbindungsring (4"') gebildet ist, der die beiden Hülsen (4' und 4") auf Höhe eines ihrer jeweiligen Ränder am Ende verbindet.

5. Variabler Kondensator nach einem der Ansprüche 1 bis 4, **dadurch gekennzeichnet, dass** das axiale Loch (2') ein Blindloch ist, und dass das erste Element (2) wenigstens eine andere Perforation (5), die mit Gewinde versehen ist oder nicht, mit axialer oder transversaler Ausdehnung, die zu dessen Montage oder Befestigung bestimmt ist, aufweist.

6. Variabler Kondensator nach einem der Ansprüche 1 bis 5, **dadurch gekennzeichnet, dass** das zweite Element (3) aus einer Schraube besteht, die auf der Seite des dem Kopf (3"') gegenüberliegenden Endes ein nicht mit Gewinde versehenes Teil (3') aufweist, das dazu bestimmt ist, vorzugsweise genau passend, in das Axialloch (2') des ersten Elements (2), eingeführt zu werden.

7. Variabler Kondensator nach den Ansprüchen 5 und 6, **dadurch gekennzeichnet, dass** das erste und zweite Element (2 und 3) auf einem Trägerkörper (6) befestigt sind, wobei das zweite Element (3) in Form einer Schraube auf Höhe seines mit Gewinde versehenen Teils (3), an seinen Kopf (3"') angrenzend, mit einer Gleitfähigkeit bezüglich des ersten Elements (2) durch Rotation um seine Längsachse verbunden ist.

8. Variabler Kondensator nach einem der Ansprüche 6 und 7, **dadurch gekennzeichnet, dass** die mit Gewinde versehenen Teile (3") und die Teile ohne Gewinde (3') der Schraube (3) im Wesentlichen identische axiale Längen aufweisen.

9. Hochfrequenzfilter, insbesondere von der Art Bandpassfilter, **dadurch gekennzeichnet, dass** er wenigstens einen variablen oder regelbaren Kondensator (1) nach einem der Ansprüche 1 bis 8 aufweist.

10. Hochleistungs-NMR-Sonde, **dadurch gekennzeichnet, dass** sie wenigstens einen variablen oder regelbaren Kondensator (1) nach einem der Ansprüche 1 bis 8 aufweist.
